# EUROPEAN PATENT SPECIFICATION

(11) **EP 2 250 704 B1**
(45) Date of publication and mention of the grant of the patent: **11.07.2012**
(21) Application number: 09717707.5
(22) Date of filing: 02.03.2009
(51) Int. Cl.: H01R 4/58, B32B 17/10, F21K 99/00

(54) **BUS BAR AND PANEL OF LAMINATED GLASS**
SAMMELSCHIENE UND PLATTE AUS VERBUNDGLAS
BARRE OMNIBUS ET PANNEAU DE VERRE FEUILLETÉ

(30) Priority: 04.03.2008 EP 08102274; 01.08.2008 EP 08104951
(43) Date of publication of application: 17.11.2010
(73) Proprietor: AGC Glass Europe, 1170 Bruxelles (Watermael-Boitsfort) (BE)
(72) Inventor: SAHYOUN, Xavier, 6040 Jumet (BE); LUYCKX, Antoine, 6040 Jumet (BE); LEFEVRE, Hugues, 6040 Jumet (BE)
(74) Representative: Verbrugge, Vivien François Emeric
(86) International application number: PCT/EP2009/052442
(87) International publication number: WO 2009/109542

(56) References cited:
- EP-A- 1 083 627
- EP-A- 1 840 449
- JP-A- 9 282 625
- US-A- 6 042 932

## Description

### DOMAIN OF THE INVENTION

The invention relates to laminated glass products especially lighting products. In particular the present invention relates to a bus bar having a conductive strip, a first insulating layer, and a second insulating layer, and to a panel of laminated glass, with a first glass substrate, a conductive layer, wherein the conductive layer is provided on the first glass substrate, and a second glass substrate, wherein the two glass substrates are laminated together via a plastics interlayer, wherein the plastics interlayer is provided on the conductive layer.

### TECHNICAL BACKGROUND

### Electrical connectors are widely used in electronic such as described in EP1083627 A1. Bus -bars is a kind of electrical connector.

Laminated glass is a type of safety glass that holds together when shattered. In the event of it breaking, it is held in place by the plastics interlayer, typically made of Polyvinyl Butyral (PVB), between its two or more layers of glass substrate. The plastics interlayer keeps the layers of glass substrate bonded even when broken, and its high strength prevents the glass substrates from breaking-up into separate sharp pieces.

Methods for manufacturing laminated glass are well-known in the automotive, aviation, and window industry and other industries since decades. A so-called sandwich of the first glass substrate, the plastics interlayer and the second glass substrate is laminated in an automated laminating line by using the procedure of calendaring and autoclaving. Calendaring means allow the pre-gluing of the sandwich under the action of a pressure imposed by two rolls applied on either side of the glass substrates, and the action of heat. The final gluing of the glass substrates by a vacuum/heating cycle, which combines pressure and temperatures, taking place during the step of autoclaving, which completely removes air bubbles in the plastics interlayer between the glass substrates. The result is a clear glass laminate well known from car windscreens.

Laminated glass panels with integrated electronic components, such as light emitting diodes (LED), are know, e. g. for displaying information or for lighting purposes. For these application areas, the manufacturing of a laminated glass panel with electronic components typically comprises the steps of depositing a conducting layer on the first layer of glass substrate, realization of electronic circuits in the conducting layer and depositing of electronic components on the conducting layer, which is connected to the electronic circuits. The plastics interlayer is then deposited on the conducting layer. The sandwich is obtained by the application of the second layer of glass on the plastics interlayer, which is then laminated as outlined before.

EP 1 840 449 describes such a panel of laminated glass with two bus bars, wherein each bus bar is adapted to provide electrical power to a plurality of electronic circuits. The bus bars are provided on the conductive layer and each bus bar comprises a plurality of spaced insulators arranged at intervals along its length so as to provide alternatingly electrical connections and insulated portions, respectively, between a conductive strip of the bus bar and the conductive layer at selected positions. Thus, it is possible to supply in an independent way several electronic circuits realized in the conducting layer.

### SUMMARY OF THE INVENTION

Accordingly, it is the object of the invention to provide a bus bar that is easy to produce in mass for a low cost and provides a high reliability of the electrical contact between the conductive strip and a conducting layer during usage.

This object is addressed by a bus bar comprising a conductive strip, a first insulating layer provided on one side of the conductive strip and adapted for holding the conductive strip, and a second insulating layer provided on the other side of the conductive strip and adapted for holding the conductive strip and the first insulating layer, wherein the second insulating layer comprises an opening for providing electrical access to the conductive strip.

Accordingly, it is an essential idea of the invention to provide a bus bar with a conductive strip which is covered from both sides from the insulating layers, wherein an opening is provided in the second insulating layer for providing electrical access to the conductive strip. The conductive strip can be realised in copper coated with tin or in any other conducting material, especially those materials with a low contact resistance, e.g. metals such as massive copper or copper alloys, silver or gold coatings. It can be solid or perforated, e. g. drawn, rolled, woven, extruded, knitted or braided. The opening can be cut or pierced by a laser beam, for example. Preferably, the opening is provided in the second insulating layer prior to manufacturing the bus bar, which improves flexibility and reduces manufacturing cost. In general, such a bus bar according to the invention is easy to manufacture and provides good long term reliability, given that the resistance to vibrations of the bus bar is improved.

According to another preferred embodiment of the invention, the first and/or second insulating layer overly the conductive strip laterally. In other words, the first and/or second insulating layer covers the conductive strip, e.g. each on one side of the conductive strip and contact each other by laterally overlying the conductive strip. In this way, and prior to providing the opening, the conductive strip is fully insulated by the first and the second insulating layer, as the first and/or a second insulating layer are preferably wider than the conductive strip.

According to another preferred embodiment of the invention, a plurality of spaced openings are provided and the spaced openings are arranged at intervals along the length of the conductive strip. This means, that electrical access is provided to the conductive strip at various spaced openings along the length of the conductive strip, wherein the openings are preferably arranged at similar intervals.

It is further preferred, that a plurality of spaced conductive strips are provided sharing a first and a second insulating layer, and electrical access is provided alternately for each conductive strip along its length. This means as well, that the first and the second insulating layer insulate each conductive strip from any other conductive strip. This means further, that the openings which provide electrical access to a first conductive strip are offset to the openings providing electrical access to a second and/or another conductive strip. Also, more than two conductive strips can be used: a plurality of spaced conductive strips can be provided sharing a plurality of insulating layers, and electrical access is provided for each conductive strip at positions along its length.

According to another preferred embodiment of the invention, the first insulating layer and/or the second insulating layer is/are provided as a plastic material and/or plastic film on which an adhesive is deposited for holding the conductive strip and for holding the second insulating layer and/or the first insulating layer, respectively. This means that the adhesive fastens the conductive strip to the first insulating layer, or the conductive strip and the first insulating layer to the second insulating layer, respectively. Preferably, the first insulating layer and/or the second insulating layer is/are provided as a tape. Using an adhesive is advantageous, since the adhesive decreases the risk of any part (for instance the conductive strips) moving during and after the production process of the busbar.

According to a preferred embodiment of the invention, the bus bar is laminated (e.g. during its production process) for fixing the first insulating layer, the conductive strip and the second insulating layer together. Such an embodiment allows a form of the bus bar which is more compact and assures a final fixation of the bus bar.

Due to the effect of lamination of the busbar, the conducting strip may penetrate into the first insulating layer, wherein the conductive strip may penetrate less into the first insulating layer at an area of an opening. The penetration depth can be influenced by putting pressure on the conductive strip or by using an insulating layer that is mechanically more resistant. Especially when using an e. g. flexible tape for the insulating layers, the lamination is advantageous since it permanently fixes the conductive strip to the first insulating and/or the second insulating, respectively.

It is further preferred, that a conductive element is provided in the opening providing electrical contact with the conductive strip. In this way, electrical access is improved, since the conductive element provides good electrical contact to the conducting strip. Preferably, the conductive element positively locks the opening and may be thicker or thinner than the second insulating layer. For the first case (thicker), the conductive element may overlap the opening on top of the second insulating layer. The conducting element may further be provided with conducting glue for gluing with the conductive strip or as at least one metal point, which can be fixed as well to the conductive strip. The conducting elements can be provided, for example as points or blobs out of a conductive material, which may become liquid during panel lamination to form a small uniform layer that reinforces the contact between the points and the conducting strips. Such an embodiment further improves the electrical contact with the conductive strip. According to another preferred embodiment of the invention, a continuous anisotropically conductive adhesive ribbon is provided between the conductive strip and the second insulating layer. It is further preferred that the continuous anisotropically conductive adhesive ribbon is provided as an anisotropically conductive double phased adhesive tape loaded with conducting particles, such as silver, or a conducting glue.

The object of the invention is further addressed by a panel of laminated glass comprising a first glass substrate, a conductive layer, wherein the conductive layer is provided on the first glass substrate, a second glass substrate, wherein the two glass substrates are laminated together via a plastics interlayer and wherein the plastics interlayer is provided on the electrically conductive coating, and a bus bar according to any of the previous embodiments of the invention, wherein in the opening the conductive strip is in electrical contact with the conductive layer and/or the conductive element.

It is further preferred that the second insulating layer is provided with an adhesive (for instance a glue) on the side facing away from the conductive strip for fixing the electrical connection between the conductive strip and the conductive layer and/or the conductive element (and for fixing the bus bar to the conductive layer). Such an adhesive can be a conductive adhesive provided on all or allmost all the surface in contact with the conductive layer of the second insulating layer or can be a non conductive adhesive provided on all the surface in contact with the conductive layer of the second insulating layer except on the spaced openings. This is advantageous, since in this way, during the panel production process, the risk that the plastic interlayer slips under the conductive strip destroying the electric connection between the conductive strip and the conductive layer is minimized. In other words, according to this embodiment of the invention the electrical contact between the conductive strip and the conducting layer is very reliable and provides a better resistance against external vibrations.

As known from prior art, electronic circuits can be defined in the conductive layer, e. g. by patterning or by ablation by a laser. The electronic circuits can further be equipped with electronic components, such as passive components such as resistors, capacitors or inductors, electronic components such as transistors, diodes, switches, microprocesors, LEDs, semiconductor lasers, etc. Usually, the electronic circuits are created in the conductive layer prior to application of the bus bar and/or prior to panel lamination.

Generally, the panel lamination allows for evacuation of any air present between the conductive strip and the conducting layer, obtaining a good electrical contact between the conductive strip and the conducting layer.

It is further preferred to reduce the thickness of the bus bar or of the second insulating layer or of the conducting strip for improving the yield and contact reliability between the conductive strip and the conductive layer.

As outlined before, the conducting elements can be provided as points or blobs out of a conductive material, which may become liquid during panel lamination to form a small uniform layer that reinforces the contact between the points and the conducting strips. Alternatively, the points or blobs may remain hard and assure an inhomogeneous contact between the conducting strips and the conducting layer. It is further preferred, that instead of points or blobs a conducting adhesive or glue is provided in the opening wherein the adhesive is preferably fixed on the conducting layer. In order to assure an even more stable electrical contact with respect to temperatures and high level of vibrations, it is further preferred to use a conductive adhesive that is thicker than the second insulating layer. In this case, the electrical contact is even maintained if the second insulating layer lifts of the conducting layer of the first glass substrate.

According to another preferred embodiment of the invention, an external connection is provided for providing electrical power to the conductive strip in the opening at the end of the conducting strip, and the external connection is electrically insulated. This means that the electrically insulated external connection provides an electrical contact to the conductive strip e. g. for connecting the conductive strip respectively the bus bar to an external power source. The contact between the external connection and the conducting layer is preferably realised by a conducting or a conductive adhesive on the external connection. It is further preferred, that a casting is provided for providing electrical contact between the external connection and the connector.

The object of the invention is further addressed by a method for manufacturing a bus bar, comprising the steps of providing a conductive strip, adhering the conductive strip onto a first insulating layer, and adhering the conductive strip and a first insulating layer with a second insulating layer, and providing electrical access to the conductive strip by an opening in the second insulating layer. With respect to this, the conductive strip is adhered by a first insulating layer from one side and by a second insulating layer from the other side. Preferably, a plurality of spaced openings are provided during the spaced openings are arranged at intervals along the length of the conducting strip.

According to a further preferred embodiment of the invention, the adhering of the conductive strip is achieved by an adhesive. In this way, the adhesive fixes the conductive strip to the first and/or second insulating layer.

The object of the invention is further addressed by a panel of laminated glass, preferably according to a previous embodiment, comprising a first glass substrate, a conductive layer, wherein the conductive layer is provided on the first glass substrate, a second glass substrate, wherein the two glass substrates are laminated together via a plastics interlayer and wherein the plastics interlayer is provided on the conductive layer, and a conductive strip is provided at an edge of the panel with a distance of at least 5 mm to the edge of the panel, wherein the conductive strip is in electrical contact with the conductive layer.

This is advantageous since it allows removing all of the air during panel lamination for avoiding that residual air prevents a good contact between the connection strip and the conductive layer, preferably after ageing. This allows further, that during calendaring and/or autoclaving and/or laminating the panel of laminated glass with the connector placed in a perpendicular direction to the rolls, to leave a space of at least 5 mm between the connector and the edge of the glass, in order to allow the air to escape.

These and other aspects of the invention will be apparent from and elucidated with reference to the embodiments described hereinafter.

### BRIEF DESCRIPTION OF THE DRAWINGS

In the drawings:
- Fig. 1: depicts a longitudinal view of a bus bar according to a preferred embodiment of the invention prior to panel lamination,
- Fig. 2: depicts a longitudinal view of the bus bar according to the preferred embodiment of the invention after panel lamination,
- Fig. 3: depicts a traverse view of a bus bar according to another preferred embodiment of the invention after the busbar lamination production process,
- Fig. 4: depicts a top view of the bus bar according to another preferred embodiment of the invention after the busbar lamination production process,
- Fig. 5: depicts a panel of laminated glass in a cross-sectional view according to another preferred embodiment of the invention,
- Fig. 6a: depicts a longitudinal view of a bus bar according to another preferred embodiment of the invention prior to panel lamination,

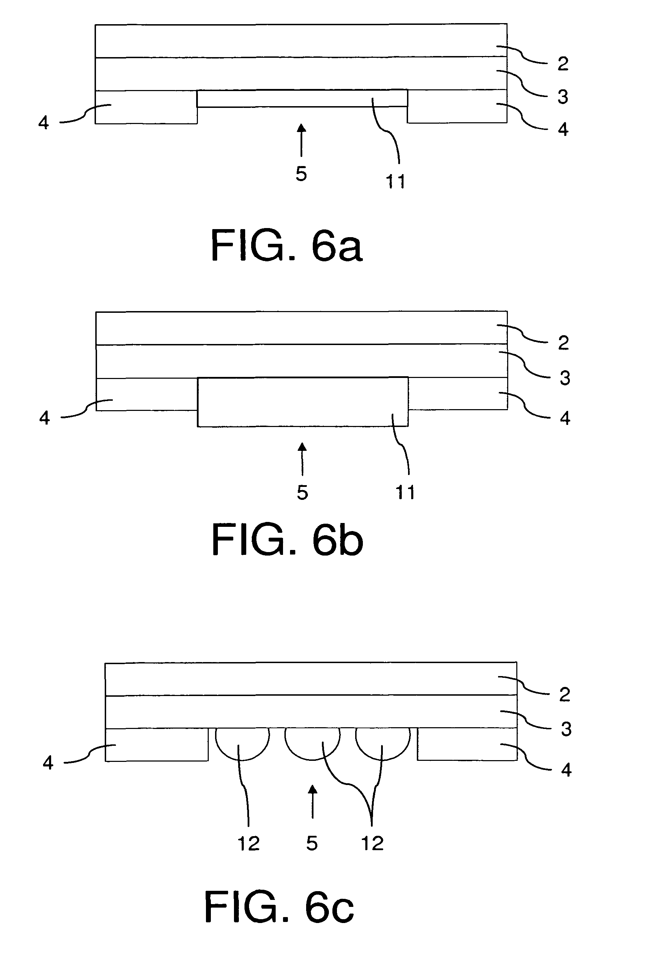

- Fig. 6a: depicts a longitudinal view of a bus bar according to another preferred embodiment of the invention after the busbar lamination production process,
- Fig. 6b: depicts a longitudinal view of a bus bar according to another preferred embodiment of the invention after the busbar lamination production process,
- Fig. 6c: depicts a longitudinal view of a bus bar according to another preferred embodiment of the invention prior to panel lamination,

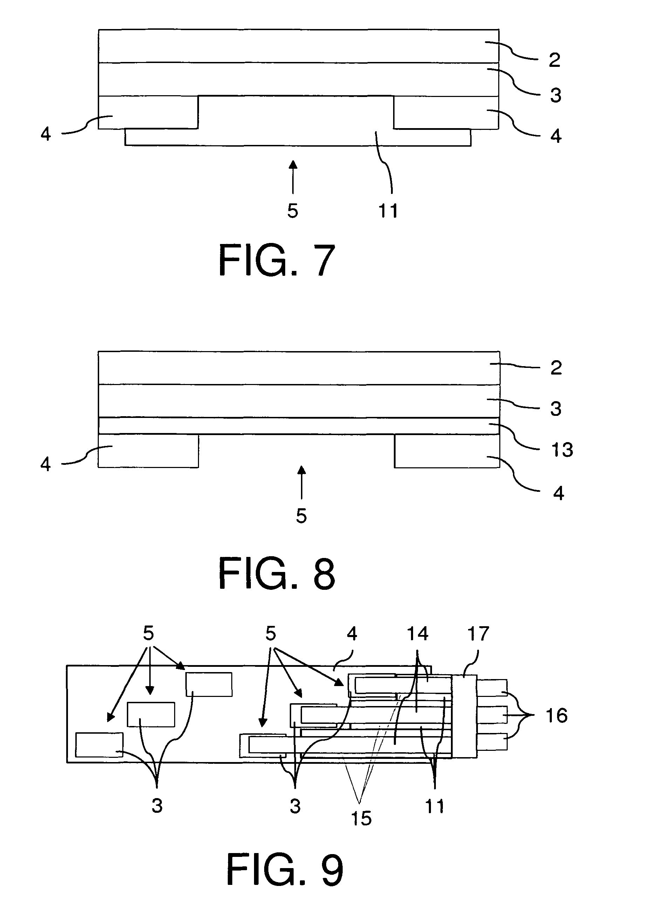

- Fig. 7: depicts a longitudinal view of a bus bar according to another preferred embodiment of the invention prior to panel lamination,
- Fig. 8: depicts a longitudinal view of a bus bar according to another preferred, embodiment of the invention prior to panel lamination, and
- Fig. 9: depicts a top view of an external connection of a bus bar according to another preferred embodiment of the invention.

### DESCRIPTION OF THE PREFERRED EMBODIMENTS

The drawings described are only schematic and are non-limiting. In the drawings, the size of some of the elements may be exaggerated and not drawn on scale for illustrative purposes. The mere fact that certain measures are recited in mutually different dependent claims does not indicate that a combination of these measures cannot be used to advantage. Any reference signs in the claims should not be construed as limiting the scope.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

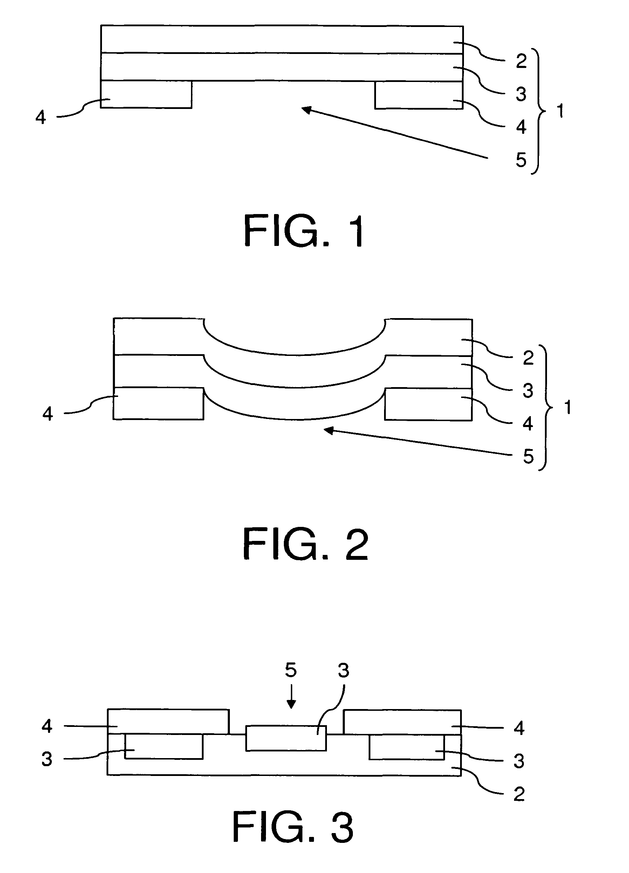

Fig. 1 shows, according to a preferred embodiment of the invention, a longitudinal view of the bus bar 1. The bus bar 1 comprises a first insulating layer 2, a conducting strip 3 and a second insulating layer 4. The first insulating layer 2 can be realized as a plastic material on which a layer of adhesive is deposited. For example, the first insulating layer 2 can be a tape sold under the trade name 3M 390 marketed by the corporation 3M, Minnesota, USA.

In order to manufacture a bus bar 1, a conducting strip 3 is deposited on the first insulating layer 2. The conducting strip 3 is preferably realized in copper, for example from Comet Metals Co. located in Walton Hills, OH. Then, the second insulating layer 4 is deposited on the first insulating layer 2 and the conducting strip 3. Insulating layer 3 further comprises an opening 5 for providing electrical access for the conducting strip 3. The second insulated layer 4 is for example a plastic film on which is deposited or applied a layer of adhesive, for example a film marketed by the corporation 3M under the commercial reference 3M 9471FL, in order to fix the second insulating layer 4 to the first insulating layer 2 and the conductive strip 3 . The opening 5 is preferably previously fixed into the second insulating layer 4 prior to fixing the second insulating layer 4 onto the first insulating layer 2 and onto the conducting strip 3. It is further equally conceivable that the second insulating layer 4 also is provided with a conductive adhesive on the side facing away from the conductive strip 3, to fix the bus bar 1.

While Fig. 1 depicts the bus bar 1 prior to panel lamination, Fig. 2 depicts the bus bar 1 in a longitudinal view after lamination. The lamination is achieved due to a classical method of lamination known from prior art, which results in a compacter form and assures a final fixation of the bus bar 1. As it can be seen from Fig. 2, and due to the effect of lamination, the bus bar 1 is "folded" which improves the yield and contact reliability, for example against vibrations, transportation or cutting of the bus bar 1.

Fig. 3 depicts a transverse view of a bus bar 1 according to another preferred embodiment of the invention after the busbars lamination production process. As it can be seen, the bus bar 1 comprises three conductive strips 3, which are covered on one side by the first insulating layer 2. Due to the effect of this lamination production process, the conducting strips 3 penetrate into the first insulating layer 2. At an opening 5 the conductive strip 3 penetrate less into the first insulating layer 2, compared to areas where the conductive strips 3 are covered from the other side by the second insulating layer 4.

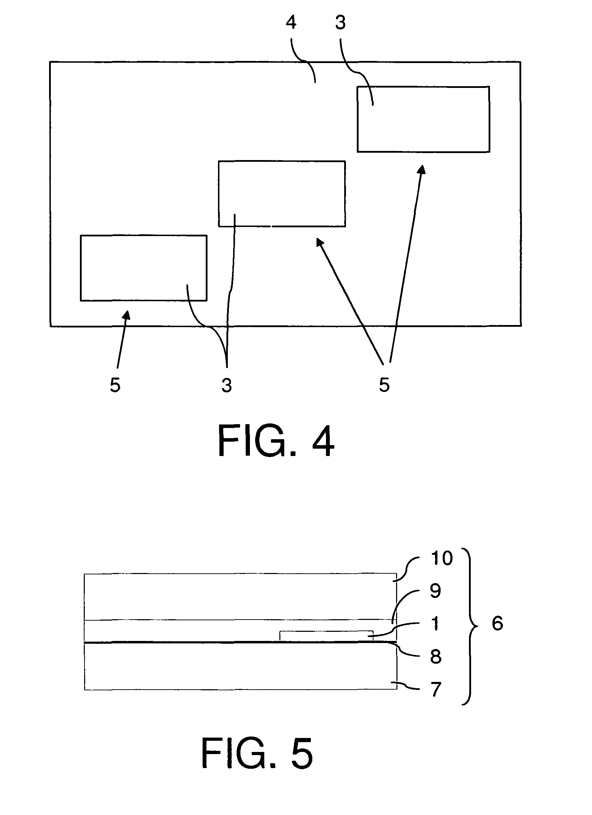

A top view of the bus bar 1 according to another preferred embodiment of the invention can be seen from Fig. 4. Three openings 5 are provided in the second insulating layer 4. Each opening 5 provides electrical access to a conductive strip 3. As can be seen, the opening 5 providing electrical access to the first conductive strip 3 is offset relative to the opening 5 providing electrical access to the second conductive strip 3 and to the opening 5 providing electrical access to the third conductive strip 3.

Fig. 5 depicts a panel of laminated glass 6 in a cross-sectional view according to another preferred embodiment of the invention. The panel of laminated glass 6 comprises a first glass substrate 7, a conductive layer 8, which is provided on the first glass substrate 7, a bus bar 1 provided on the conductive layer 8, a plastics interlayer 9 provided on the conductive layer 8 and on the bus bar 1, and a second glass substrate 10. Electrical contact is provided between the conductive strip 3 of the bus bar 1 and the conductive layer 8.

Fig. 6a, Fig. 6b and Fig. 6c depict a longitudinal view of a bus bar 1 according to another preferred embodiments of the invention prior to lamination. As it can be seen from Fig. 6a, a conducting element 11 is provided in the opening 5, wherein the conducting element 11 is thinner than the second insulating layer 4. The conducting element 11 improves electrical contact to the conducting layer 8 and to the conducting strip 3 after panel lamination. Fig. 6b depicts a bus bar 1 with a conducting element 11 that is thicker than the second insulating layer 4. Such a thicker conducting element 11 assures good electrical contact between the conducting strip 3 and the conducting layer 8 of the panel of laminated glass 6. Fig. 6c depicts metal points 12 provided as conducted elements 11. Alternatively, these metal points 12 can be soldered to the conducting layer 8 of first glass substrate 7.

Fig. 7 depicts a further longitudinal view of a bus bar 1 according to another preferred embodiment of the invention prior to panel lamination, wherein the conducting element 11 overlaps the opening 5. In this way, the electrical contact between the conducting strip 3 and the conducting layer 8 is improved.

Fig. 8 depicts a bus bar 1 according to another preferred embodiment of the invention prior to lamination, wherein a continuous anisotrophically conductive adhesive ribbon 13 is provided between the conductive strip 3 and the second insulating layer 4.

According to another preferred embodiment of the invention and as depicted in Fig. 9, external connections 14 are provided, which provide electrical contact to the conductive strip 3 in the opening 5 at the end of the conductive strip 3. The external connection 14 is preferably electrically insulated by an insulator 15. Further, a connector 16 is provided for connecting cables or external power sources. For example, the connector 16 can be provided as "faston" manufactured by the corporation Tyco. The external connection 14 connects to the conductive strip 3 by means of gluing or an adhesive. Further, a casting 17 is provided for providing electrical contact between the external connection 14 and the connector 16. Preferably, and as shown in Fig. 9, the casting 17 provides electrical contact between three external connections 14 and three connectors 16.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. The mere fact that certain measures are recited in mutually different dependent claims does not indicate that a combination of these measured cannot be used to advantage. Any reference signs in the claims should not be construed as limiting the scope.

## Claims

1. Bus bar comprising
a conductive strip (3),
a first insulating layer (2) provided on one side of the conductive strip (3) and adapted for holding the conductive strip (3), and
a second insulating layer (4) provided on the other side of the conductive strip (3) and adapted for holding the conductive strip (3) and the first insulating layer (2), wherein
the second insulating layer (4) comprises an opening (5) for providing electrical access to the conductive strip (3),
wherein the first insulating layer (2) and/or the second insulating layer (4) is/are provided as a plastic material and/or plastic film on which an adhesive is deposited for holding the conductive strip (3) and for holding the second insulating layer (4) and/or the first insulating laver (2), respectively.

2. Bus bar (1) according to claim 1, wherein the first insulating layer (2) and/or the second insulating layers (4) laterally overly the conductive strip (3).

3. Bus bar (1) according to claim 1 or 2, wherein a plurality of spaced openings (5) is provided, and the spaced openings (5) are arranged at intervals along the length of the conductive strip (3).

4. Bus bar (1) according to any of claims 1 to 3, wherein a plurality of spaced conductive strips (3) are provided sharing the first insulating layer (2) and the second insulating layer (4), and electrical access is provided alternately for each conductive strip (3).

5. Bus bar (1) according to any of claims 1 to 4, wherein the bus bar (1) is laminated during its production process for fixing the first insulating layer (2), the conductive strip (3) and the second insulating layer (4) together.

6. Bus bar (1) according to any of claims I to 5, wherein a conductive element (11) is provided in the opening (5) providing electrical contact with the conductive strip (3).

7. Bus bar (1) according to any of claims 1 to 6, wherein the conductive element (11) is thicker than the second insulating layer (4) and overlaps the opening on top of the second insulating layer (4).

8. Bus bar (1) according to any of claims 1 to 7, wherein a continuous anisotropically conductive adhesive ribbon (13) is provided between the conductive strip (3) and the second insulating layer (4).

9. Panel of laminated glass (6), comprising
a first glass substrate (7),
a conductive layer (8), wherein the conductive layer (8) is provided on the first glass substrate (7),
a second glass substrate (10), wherein the two glass substrates (7, 10) are laminated together via a plastics interlayer (9), wherein the plastics interlayer (9) is provided on the conductive layer (8), and
a bus bar (1) according to any of claims 1 to 8, wherein in the opening (5) the conductive strip (3) is in electrical contact with the conductive layer (8) and/or the conductive element (11).

10. Panel (6) according to claim 9, wherein an adhesive is provided on the bus bar in order to fix it to the conductive layer (8).

11. Panel (6) according to claim 9 or 10, wherein an external connection (I4) is provided for providing electrical power to the conductive strip (3) in the opening (5) at the end of the conductive strip (3), and wherein the external connection (14) is electrically insulated.

12. Panel (6) according to claim 11, wherein a casting (17) is provided for providing electrical contact between the external connection (14) and a connector (16).

13. Method for manufacturing a bus bar (1), comprising the steps:
providing a conductive strip (3),
adhering the conductive strip (3) onto a first insulating layer (2),
adhering the conductive strip (3) and the first insulating layer (2) with a second insulating layer (4), and
providing electrical access to the conductive strip (3) by an opening in the second insulating layer (4),
wherein the first insulating layer (2) and/or the second insulating layer (4) is/are provided as a plastic material and/or plastic film on which an adhesive is deposited for holding the conductive strip (3) and for holding the second insulating layer (4) and/or the first insulating layer (2), respectively -

14. Method according to claim 13, wherein the adhering of the conductive strip (3) is achieved by an adhesive.

## Patentansprüche

1. Sammelschiene (1), umfassend
einen leitfähigen Streiten (3),
eine erste isolierende Schicht (2), bereitgestellt auf einer Seite des leitfähigen Streifens (3) und angepasst, um den leitfähigen Streifen (3) zu tragen, und eine zweite isolierende Schicht (4), bereitgestellt auf der anderen Seite des leitfähigen Streifens (3) und angepasst, um den leitfähigen Streifen (3) und die erste isolierende Schicht (2) zu tragen, wobei die zweite isolierende Schicht (4) eine Öffnung (5), um elektrischen Zugang zu dem leitfähigen Streifen (3) bereitzustellen, umfasst,
wobei die erste isolierende Schicht (2) und/oder die zweite isolierende Schicht (4) als ein Kunststoffmaterial und/oder ein Kunststoff-Film, auf dem ein Haftmittel aufgebracht ist, um den leitfähigen Streifen (3) zu tragen und um jeweils die zweite isolierende Schicht (4) und/oder die erste isolierende Schicht (2) zu tragen, bereitgestellt ist/sind.

2. Sammelschiene (1) nach Anspruch 1, wobei die erste isolierende Schicht (2) und/oder die zweite Isolierende Schicht (4) den leitfähigen Streifen (3) seitlich überlagert/n.

3. Sammelschiene (1) nach Anspruch 1 oder 2, wobei eine Mehrzahl von beabstandeten Öffnungen (5) bereitgestellt ist und die beabstandeten Öffnungen (5) in Intervallen entlang der Länge des leitfähigen Streifens (3) angeordnet sind.

4. Sammelschiene (1) nach einem der Ansprüche 1 bis 3, wobei eine Mehrzahl von beabstandeten leitfähigen Streifen (3), die sich die erste isolierende Schicht (2) und die zweite isolierende Schicht (4) teilen, bereitgestellt sind und elektrischer Zugang abwechselnd für jeden leitfähigen Streifen (3) bereitgestellt ist.

5. Sammelschiene (1) nach einem der Ansprüche 1 bis 4, wobei die Sammelschiene (1) nährend ihres Herstellungsverfahrens laminiert wird, um die erste isolierende Schicht (2), den leitfähigen Streifen (3) und die zweite isolierende Schicht (4) miteinander zu verbinden.

6. Sammelschiene (1) nach einem der Ansprüche 1 bis 5, wobei ein leitfähiges Element (11) in der Öffnung (5) bereitgestellt ist, wodurch elektrischer Kontakt mit dem leitfähigen Streifen (3) bereitgestellt wird.

7. Sammelschiene (1) nach einem der Ansprüche 1 bis 6, wobei das leitfähige Element (11) dicker Ist als die zweite isolierende Schicht (4) und die Öffnung oberseitig der zweiten isolierenden Schicht (4) überlappt.

8. Sammelschiene (1) nach einem der Ansprüche 1 bis 7, wobei ein kontinuierliches, anisotrop leitfähiges Klebeband (13) zwischen dem leitfähigen Streifen (3) und der zweiten isolierenden Schicht (4) bereitgestellt ist.

9. Platte aus Verbundglas (6), umfassend
ein erstes Glassubstrat (7),
eine leitfähige Schicht (8), wobei die leitfähige Schicht (8) auf dem ersten Glassubstrat (7) bereitgestellt ist,
ein zweites Glassubstrat (10), wobei die beiden Glassubstrate (7, 10) mittels einer Kunststoff-Zwischenschicht (9) zusammenlaminiert sind, wobei die Kunststoff-Zwischenschicht (9) auf der leitfähigen Schicht (8) bereitgestellt ist, und eine Sammelschiene (1) nach einem der Ansprüche 1 bis 8, wobei der leitfähige Streifen (3) in der Öffnung (5) in elektrischem Kontakt mit der leitfähigen Schicht 8 und/oder dem leitlähigen Element (11) ist.

10. Platte (6) nach Anspruch 9, wobei ein Haftmittel auf der Sammelschiene (1) bereitgestellt ist, um sie an die leitfähige Schicht (8) zu fixieren.

11. Platte (6) nach Anspruch 9 oder 10, wobei eine externe Verbindung (14) bereitgestellt ist, um an den leitfähigen Streifen (3) In der Öffnung (5) am Ende des leitfähigen Streifens (3) elektrischen Strom anzulegen, und wobei die externe Verbindung (14) elektrisch isoliert ist.

12. Platte (6) nach Anspruch 11, wobei ein Gussteil (17) bereitgestellt ist, um elektrischen Kontakt zwischen der externen Verbindung (14) und einem Anschluß (16) bereitzustellen.

13. Verfahren zur Herstellung einer Sammelschiene (1), umfassend die Schritte:
Bereitstellen eines leitfähigen Streifens (3),
Anhaften des leitfähigen Streifens (3) auf eine erste isolierende Schicht (2),
Anhaften des leltfähigen Streifens (3) und der ersten isolierenden Schicht (2) an eine zweite isolierende Schicht (4) und
Bereitstellen von elektrischem Zugang zu dem leitfähigen Streifen (3) durch eine Öffnung in der zweiten Isolierenden Schicht (4),
wobei die erste isolierende Schicht (2) und/oder die zweite Isolierende Schicht (4) als ein Kunststoffmaterial und/oder ein Kunststoff-Film, auf dem ein Haftmittel aufgebracht ist, um den leitfähigen Streifen (3) zu tragen und um jeweils die zweite isolierende Schicht (4) und/oder die erste isolierende Schicht (2) zu tragen, bereitgestellt ist/sind.

14. Verfahren nach Anspruch 13, wobei das Anhaften des leitfähigen Streifens (3) durch ein Haftmittel erreicht wird.

## Revendications

1. Une barre omnibus comprenant:
une barrette conductrice (3),
une première couche isolante (2) disposée sur une face de la barrette conductrice (3) et adaptée pour maintenir la barrette conductrice (3), et
une seconde couche isolante (4) disposée sur l'autre face de la barrette conductrice (3) et adaptée pour maintenir la barrette conductrice (3) et la première couche isolante (2) dans laquelle
la seconde couche isolante (4) comprend une ouverture (5) pour permettre l'accès électrique à la barrette conductrice (3),
dans laquelle la première couche isolante (2) et/ou la seconde couche isolante (4) ont/a la forme d'une matière plastique et/ou d'un film en plastique sur laquelle/lequel est déposé un adhésif pour maintenir la barrette conductrice (3) et pour maintenir respectivement la seconde couche isolante (4) et/ou la première couche isolante (2).

2. La barre omnibus (1) selon la revendication 1, dans laquelle la première couche isolante (2) et/ou la seconde couche isolante (4) recouvre(nt) latéralement la barrette conductrice (3).

3. La barre omnibus (1) selon la revendication 1 ou 2, dans laquelle sont réalisées une pluralité d'ouvertures espacées (5), et les ouvertures espacées (5) sont disposées à des intervalles le long de la longueur de la barrette conductrice (3).

4. La barre omnibus (1) selon l'une quelconque des revendications 1 à 3, dans laquelle sont disposées une pluralité de barrettes conductrices (3) partageant la première couche isolante (2) et la seconde couche isolante (4), et un accès électrique est fourni en alternance pour chaque barrette conductrice (3).

5. La barre omnibus (1) selon l'une quelconque des revendications 1 à 4, dans laquelle la barre omnibus (1) est laminée durant son procédé de production en vue de fixer la première couche isolante (2), la barrette conductrice (3) et la seconde couche isolante (4).

6. La barre omnibus (1) selon l'une quelconque des revendications 1 à 5, dans laquelle un élément conducteur (11) est fourni dans l'ouverture (5) pour assurer un contact électrique avec la barrette conductrice (3).

7. La barre omnibus (1) selon l'une quelconque des revendications 1 à 6, dans laquelle l'élément conducteur (11) est plus épais que la seconde couche isolante (4) et chevauche l'ouverture au-dessus de la seconde couche isolante (4).

8. La barre omnibus (1) selon l'une quelconque des revendications 1 à 7, dans laquelle un ruban adhésif continu anisotropiquement conducteur (13) est disposé entre la barrette conductrice (3) et la seconde couche isolante (4).

9. Un panneau de verre feuilleté (6), comprenant
un premier substrat en verre (7),
une couche conductrice (8), dans laquelle la couche conductrice (8) est disposée sur le premier substrat en verre (7),
un second substrat en verre (10), dans lequel les deux substrats en verre (7, 10) sont laminés l'un sur l'autre par le biais d'une couche intermédiaire en plastique (9), dans lequel la couche intermédiaire en plastique (9) est disposée sur la couche conductrice (8), et
une barre omnibus (1) selon l'une quelconque des revendications 1 à 8, dans laquelle dans l'ouverture (5), la barrette conductrice (3) est en contact électrique avec la couche conductrice (8) et/ou l'élément conducteur (11).

10. Le panneau (6) selon la revendication 9, dans lequel un adhésif est fourni sur la barre omnibus afin de fixer celui-ci à la couche conductrice (8).

11. Le panneau (6) selon la revendication 9, dans lequel une connexion externe (14) est fournie pour fournir une puissance électrique à la barrette conductrice (3) dans l'ouverture (5) à l'extrémité de la barrette conductrice (3), et dans lequel la connexion externe (14) est électriquement isolée.

12. Le panneau (6) selon la revendication 11, dans lequel est disposée une pièce moulée (17) pour fournir un contact électrique entre la connexion externe (14) et un connecteur (16).

13. Une méthode de fabrication d'une barre omnibus (1), comprenant les étapes suivantes :
fournir une barrette conductrice (3),
coller la barrette conductrice (3) sur une première couche isolante (2),
coller la barrette conductrice (3) et la première couche isolante (2) à une seconde couche isolante (4), et
fournir un accès électrique à la barrette conductrice (3) par une ouverture dans la seconde couche isolante (4),
dans laquelle la première couche isolante (2) et/ou la seconde couche isolante (4) ont/a la forme d'une matière plastique et/ou d'un film en plastique sur laquelle/lequel est déposé un adhésif en vue de maintenir la barrette conductrice (3) et de maintenir respectivement la seconde couche isolante (4) et/ou la première couche isolante (2).

14. La méthode selon la revendication 13, dans laquelle le collage de la barrette conductrice (3) est réalisé au moyen d'un adhésif.
